# EUROPEAN PATENT APPLICATION

(11) **EP 4 656 401 A1**
(43) Date of publication of application: **03.12.2025**
(21) Application number: 25178587.9
(22) Date of filing: 23.05.2025
(51) Int. Cl.: B41J 29/377, B41J 2/14

(54) **LIQUID DISCHARGE HEAD AND LIQUID DISCHARGE APPARATUS**

(30) Priority: 29.05.2024 JP 2024086946
(71) Applicant: CANON KABUSHIKI KAISHA, Tokyo 146-8501 (JP)
(72) Inventor: OSAKI, Yasuhiko, Tokyo 146-8501 (JP); IWANO, Takuya, Tokyo 146-8501 (JP); KOMAMIYA, Yumi, Tokyo 146-8501 (JP); BOERSTAL, Henricus Gerardus Jozef, Tokyo 146-8501 (JP); HOLLANDS, Peter Joseph, Tokyo 146-8501 (JP)
(74) Representative: Canon Europe Limited

(57) **Abstract**

A liquid discharge head includes a first discharge element board and a second discharge element board each having a discharge element for discharging a liquid from a discharge port, first and second drive circuit boards provided with first and second driving elements for driving the discharge element on the first and second discharge element boards, and a cooling member configured to come into contact with the first and the second drive circuit boards, wherein the cooling member includes an inlet configured to introduce a coolant from outside, an outlet configured to guide the coolant to the outside, first and second coolant flow paths disposed to sandwich the inlet and configured to connect the inlet and the outlet and cool the first and second drive circuit boards respectively.

## Description

### BACKGROUND OF THE INVENTION

### Field of the Invention

The present disclosure relates to a liquid discharge head and a liquid discharge apparatus.

### Description of the Related Art

High-speed recording has been demanded for liquid discharge apparatuses used in professional-use applications including business, commercial, and industrial applications. To achieve high-speed recording, there has been proposed a liquid discharge head on which a plurality of discharge modules is mounted to increase the one-pass discharge width. The discharge modules of such a liquid discharge head may be provided with a driving element for driving a discharge element. To achieve high-speed recording, heat generation of the driving element becomes an issue that needs to be overcome.

Japanese Patent Application Laid-Open No. 2006-199021 discusses a technique for bringing heat sinks for cooling a drive circuit board on which driving elements are mounted into contact with the driving elements and supplying a coolant to the heat sinks in parallel to cool the driving elements.

Increasing the number of discharge elements to achieve the high-speed recording will increase the number of driving elements and the number of drive circuit boards on which the driving elements are mounted. With the technique discussed in Japanese Patent Application Laid-Open No. 2006-199021, if the number of drive circuit boards is increased, the number of heat sinks for cooling the driving elements and the number of flow paths for supplying a coolant to the heat sinks need to be the same as the number of drive circuit boards, which leads to an increase in the number of parts. This may possibly make it difficult to lay out supply paths to the heat sinks in a case where a plurality of discharge modules is arranged in a staggered pattern. Further, while an independent heat sink is provided for each of the drive circuit boards, there is no disclosure of a configuration for dispersing a cooling load of each of the heat sinks in a case where amounts of heat generation of the drive circuit boards are uneven. Accordingly, there has been a demand for a configuration for efficiently and equally cooling the drive circuit boards even with the increased number of driving elements and dispersing the cooling load in a case where the amounts of heat generated by the driving elements are uneven. The configuration enables increasing the degree of freedom in layout of the coolant supply paths to the heat sinks.

The present disclosure is directed to efficiently cooling the driving elements.

### SUMMARY OF THE INVENTION

According to an aspect of the present disclosure, there is provided a liquid discharge head as specified in claims 1 to 6. According to a second aspect of the present disclosure, there is provided a liquid discharge apparatus as specified in claim 7.

Further features of the present invention will become apparent from the following description of embodiments with reference to the attached drawings.

### BRIEF DESCRIPTION OF THE DRAWINGS

Fig. 1 is a schematic view illustrating an example of a liquid discharge apparatus.
Fig. 2 is a perspective view illustrating a liquid discharge head.
Fig. 3 is a perspective view illustrating the liquid discharge head.
Fig. 4 is an exploded perspective view illustrating the liquid discharge head.
Fig. 5 illustrates an electrical connection configuration of the liquid discharge head.
Fig. 6 is a perspective view illustrating a liquid discharge unit.
Fig. 7 is a perspective view illustrating the liquid discharge unit.
Fig. 8 is an exploded perspective view illustrating the liquid discharge unit.
Fig. 9 is an enlarged view illustrating an electrode of the liquid discharge unit.
Fig. 10 is a perspective view illustrating a support unit.
Fig. 11 is a plan view illustrating the liquid discharge head assembled to the support unit, as viewed from the discharge surface side.
Fig. 12 is a cross-sectional view taken along line XII-XII in Fig. 11.
Fig. 13 is a cross-sectional view taken along line XIII-XIII in Fig. 11.
Fig. 14 is a cross-sectional view taken along line XIV-XIV in Fig. 11.
Figs. 15A and 15B illustrate a connecting configuration of liquid members between the support unit and a liquid supply unit.
Fig. 16 is a cross-sectional view illustrating a fluid connecting portion between the liquid supply unit and liquid supply members.
Fig. 17 illustrate a connecting configuration of liquid flow paths of the support unit.
Fig. 18 illustrate a connecting configuration of liquid flow paths of the liquid discharge unit.
Fig. 19 illustrate a fluid-connecting configuration in a discharge element board.
Fig. 20 is a perspective view illustrating a cooling unit.
Fig. 21 is an exploded view illustrating the cooling unit.
Fig. 22 is a cross-sectional view taken along line XXII-XXII in Fig. 20.
Figs. 23A and 23B are cross-sectional views illustrating an electrical connection portion between the main body of the liquid discharge apparatus and the liquid discharge head.

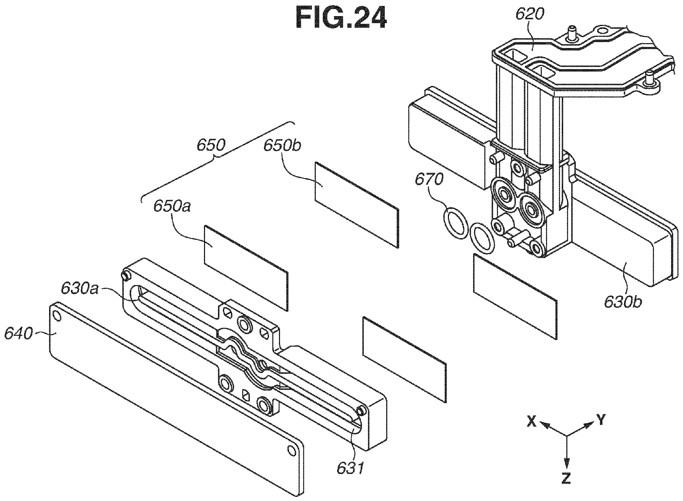

Fig. 24 is another exploded view illustrating the cooling unit.

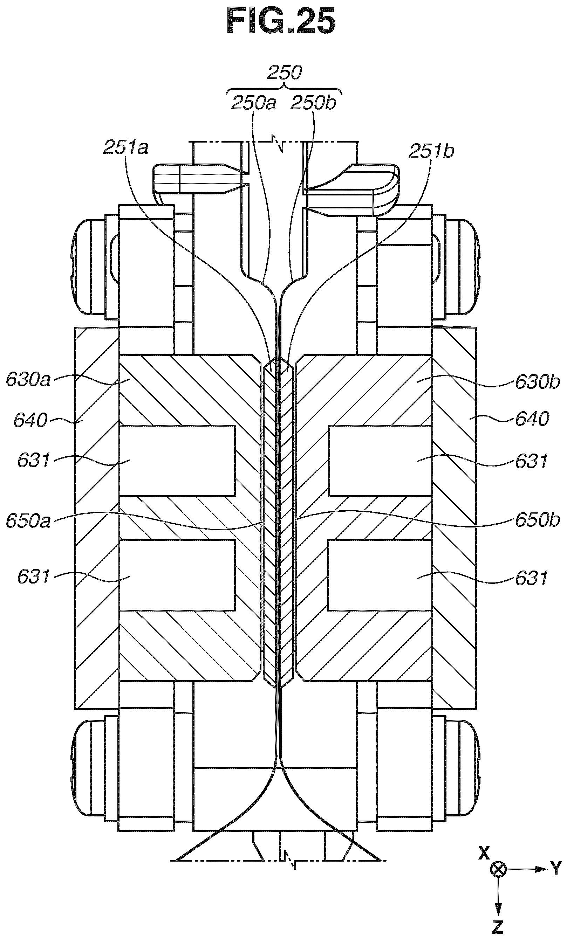

Fig. 25 is a cross-sectional view illustrating the cooling unit.
Fig. 26 is a plan view illustrates the cooling unit.

### DESCRIPTION OF THE EMBODIMENTS

Embodiments of the present disclosure will be described below with reference to the drawings. However, the following descriptions do not limit the scope of the present disclosure. Each of the embodiments of the present invention described below can be implemented solely or as a combination of a plurality of the embodiments or features thereof where necessary or where the combination of elements or features from individual embodiments is beneficial. A plurality of features are described in the embodiments, but not all the plurality of features are always essential to the invention. The plurality of features can also be arbitrarily combined. Furthermore, in the accompanying drawings, the same or similar components are assigned the same reference numerals, and the redundant description may be omitted. While the embodiments will be described below using an example of a method for discharging liquid by driving a piezoelectric element, the scope of the present disclosure also includes a liquid discharge head employing a thermal method that discharges liquid by using air bubbles generated by a heater element, and also includes a liquid discharge head employing another liquid discharge method. More specifically, the liquid discharge head may be a head including any energy generation element configured to generate energy for discharging liquid.

The liquid discharge apparatus according to the embodiments may be an ink jet recording apparatus (recording apparatus) where a liquid such as ink circulates between a tank and a liquid discharge head. However, the recording apparatus may be of another form. For example, a form may be used where ink does not circulate, a tank is disposed on each of the upstream and downstream sides of a liquid discharge head, and the ink flows from one tank to the other tank to make the ink flow in a pressure chamber. The apparatus according to the present disclosure is not limited to a recording apparatus that discharges ink and may be a liquid discharge apparatus that discharges any liquid.

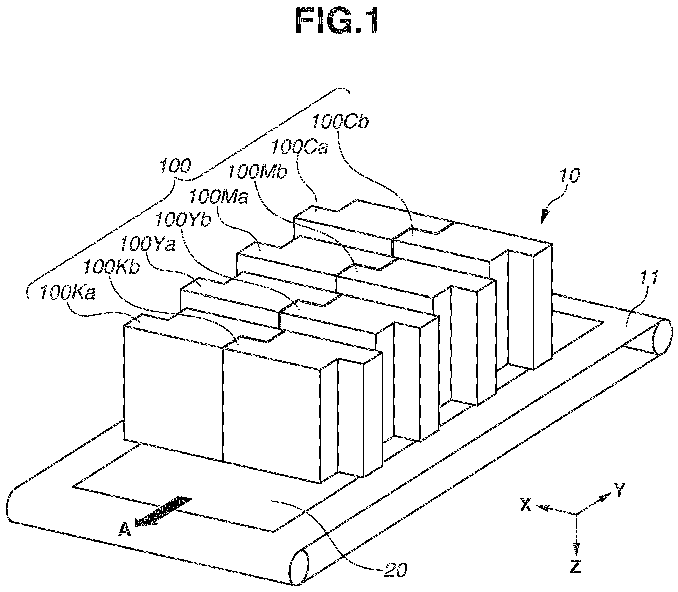

Fig. 1 is a schematic view illustrating an example of a liquid discharge apparatus 10 according to a first embodiment. The liquid discharge apparatus 10 includes liquid discharge heads 100 of what is called a one-pass type. When recording an image in a predetermined region on a recording medium 20, the liquid discharge heads 100 complete recording of the image in the predetermined region by one movement of the recording medium 20 once.

The liquid discharge heads 100 include discharge ports arranged over an entire width (in an X direction in Fig. 1) of the recording medium 20. The recording medium 20 is conveyed in a direction of an arrow A by a conveyance unit 11, and recording is performed thereon by the liquid discharge heads 100. The liquid discharge heads 100 according to the present embodiment support four colors in total: cyan, magenta, yellow, and black. More specifically, the liquid discharge heads 100 include two heads for each color, namely, cyan heads 100Ca and 100Cb, magenta heads 100Ma and 100Mb, yellow heads 100Ya and 100Yb, and black heads 100Ka and 100Kb. The following description will be provided focusing on one of the eight heads. For simplicity of the description, any one head will be described as the liquid discharge head 100. The liquid discharge head 100 according to the present disclosure may be a head of any form, and is not limited to the head in the example illustrated in Fig. 1.

In the present embodiment, descriptions are provided on the premise that a +Z direction is the direction of gravity in which a liquid is discharged, a +Y direction is an upstream side in the conveyance direction of the recording medium 20, and a +X direction is an arrangement direction in which discharge ports are arranged on the liquid discharge head 100.

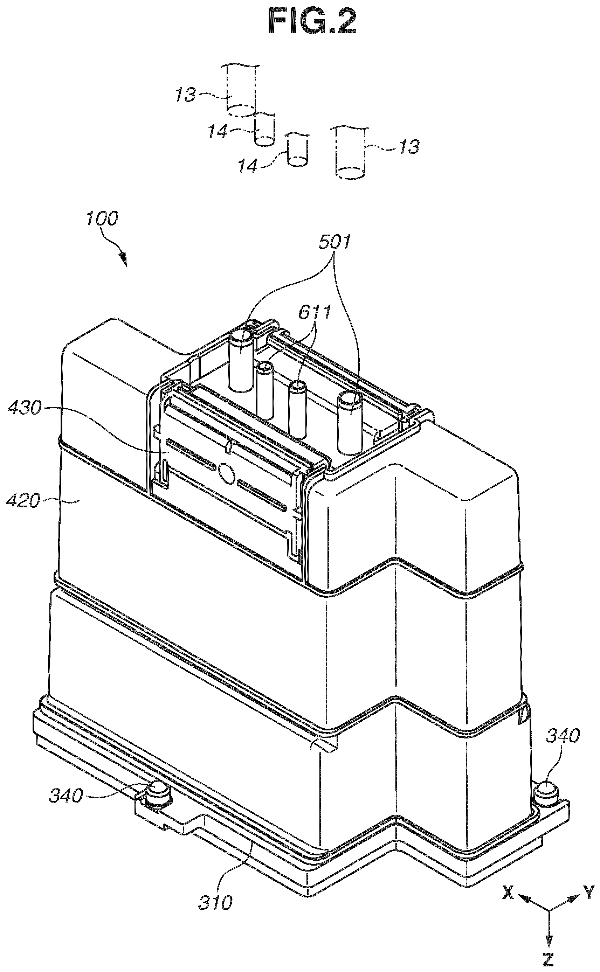

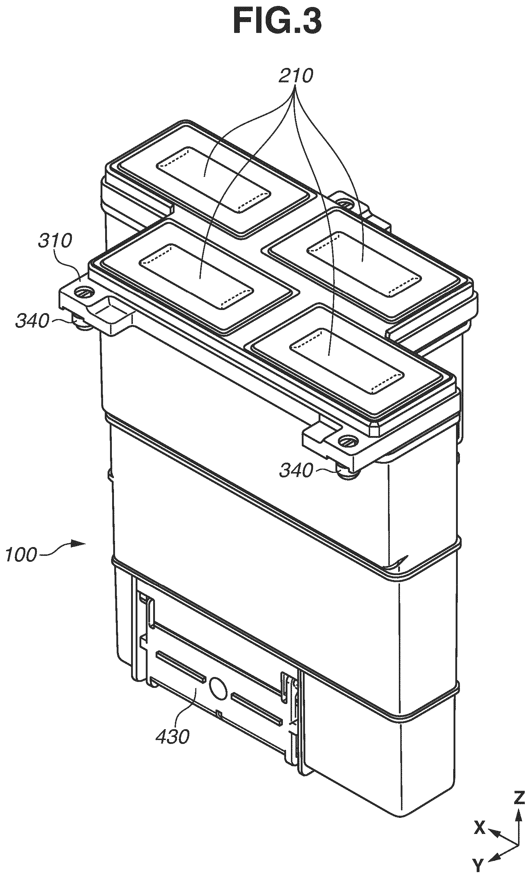

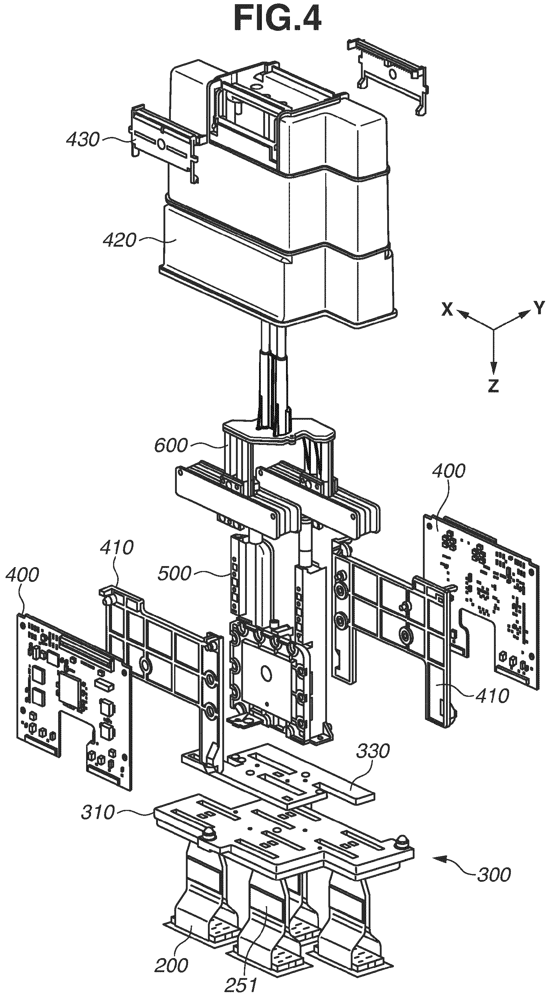

Fig. 2 is a perspective view illustrating the liquid discharge head 100 according to the present embodiment. Fig. 3 is a perspective view illustrating the liquid discharge head 100 according to the present embodiment viewed from a direction different from the direction of Fig. 2. Fig. 4 is an exploded perspective view illustrating the liquid discharge head 100 according to the present embodiment. A configuration of the liquid discharge head 100 will be described with reference to Figs. 2 to 4. As described above, one of the eight heads illustrated in Fig. 1 will be described as the liquid discharge head 100 in the following description.

As illustrated in Fig. 3, the liquid discharge head 100 includes four discharge element boards 210 capable of discharging a liquid, which are arranged in a staggered pattern on a support member 310. The liquid discharge head 100 is positioned on a main body of the liquid discharge apparatus 10 by reference members 340. As illustrated in Fig. 2, liquid connecting members 501 and coolant connecting members 611 are disposed on an upper part of the liquid discharge head 100. The liquid connecting members 501 are connected with liquid supply members 13 on a main body side of the liquid discharge apparatus 10, and the coolant connecting members 611 are connected with coolant supply members 14 on the main body side of the liquid discharge apparatus 10. Thus, a liquid such as ink and a coolant are supplied from the main body of the liquid discharge apparatus 10 to the liquid discharge head 100.

An outer case of the liquid discharge head 100 is provided with a cover member 420 and an electrical connection portion cover member 430 for covering and protecting an electric substrate, an electrical connection portion, and the like. As illustrated in Fig. 4, the liquid discharge head 100 includes a support unit 300 including the support member 310, electric wiring boards 400, and electric wiring board support members 410 for supporting the electric wiring boards 400. The liquid discharge head 100 also includes a liquid supply unit 500 for supplying a liquid to liquid discharge units 200 via the support unit 300, and a cooling unit 600 for cooling a drive circuit. The liquid discharge head 100 includes the plurality of liquid discharge units 200, and more specifically, includes four liquid discharge units 200. A configuration of each component of the liquid discharge head 100 will be described in detail below.

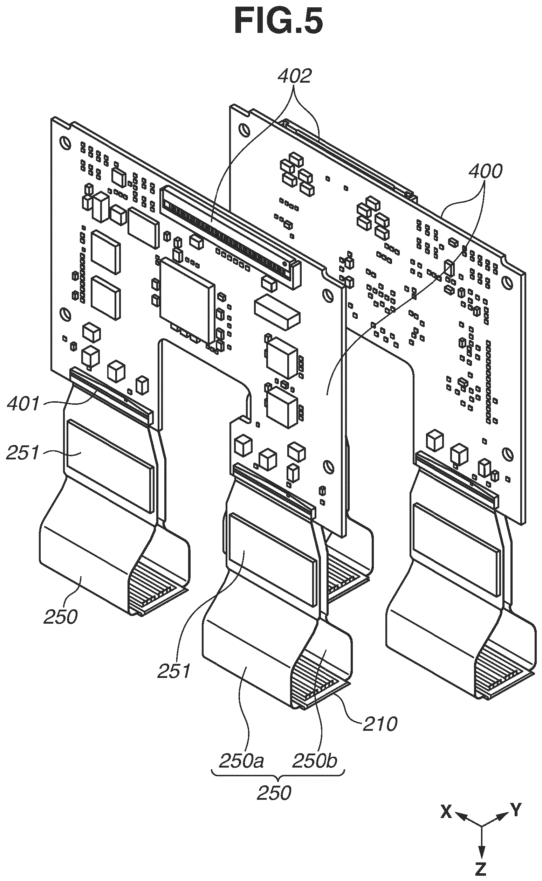

Fig. 5 illustrates an electrical connection configuration of the liquid discharge head 100 according to the present embodiment. The main body of the liquid discharge apparatus 10 and the discharge element boards 210 are electrically connected via flexible wiring boards 250 and the electric wiring boards 400. The electric wiring boards 400 are electrically connected with a control unit (not illustrated) on the main body of the liquid discharge apparatus 10 by electric connection terminals 402. Discharge driving signals and power necessary for discharging are supplied to the electric wiring boards 400 via the electric connection terminals 402. The electric wiring boards 400 and the flexible wiring boards 250 are electrically connected by electrical connection portions 401. By concentrating wiring by electric circuits in the electric wiring boards 400, the number of terminals of the electric connection terminals 402 can be reduced in comparison with the number of terminals of the discharge element board 210. Accordingly, this reduces the number of electrical connection portions 401 that need to be removed when the liquid discharge head 100 is assembled to the liquid discharge apparatus 10 or when the liquid discharge head 100 is replaced. Each flexible wiring board 250 is provided with a drive circuit board 251 for driving discharge elements of the discharge element board 210. The drive circuit board 251 is provided with a driving element for driving the discharge elements. A discharge driving signal supplied to the electric wiring board 400 is input to the drive circuit board 251.

In the drive circuit board 251, drive control for driving each recording element is performed according to the discharge driving signal.

As illustrated in Fig. 5, in the present embodiment, one liquid discharge unit 200 includes two flexible wiring boards 250, namely, a flexible wiring board a 250a and a flexible wiring board b 250b. In the following descriptions, when an individual flexible wiring board is described, the flexible wiring board is referred to as the flexible wiring board a 250a or the flexible wiring board b 250b, and when an item common to both of the flexible wiring boards is described, the flexible wiring board is simply referred to as the flexible wiring board 250. Further, the drive circuit board 251 disposed on the flexible wiring board a 250a is referred to as a drive circuit board a 251a including a driving element a. The drive circuit board 251 disposed on the flexible wiring board b 250b is referred to as a drive circuit board b 251b including a driving element b. In the following description, when an individual drive circuit board is described, the drive circuit board is referred to as the drive circuit board a 251a or the drive circuit board b 251b, and when an item common to both of the drive circuit boards is described, the drive circuit board is simply referred to as the drive circuit board 251.

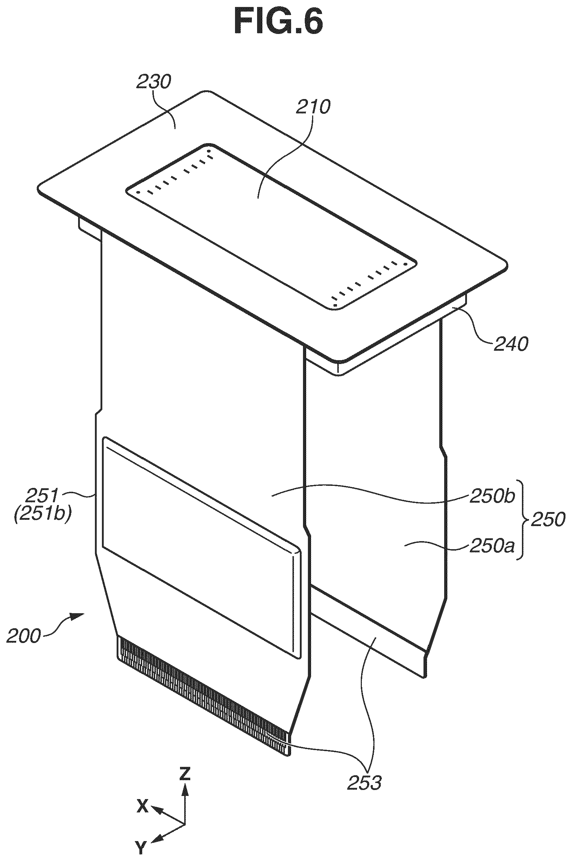

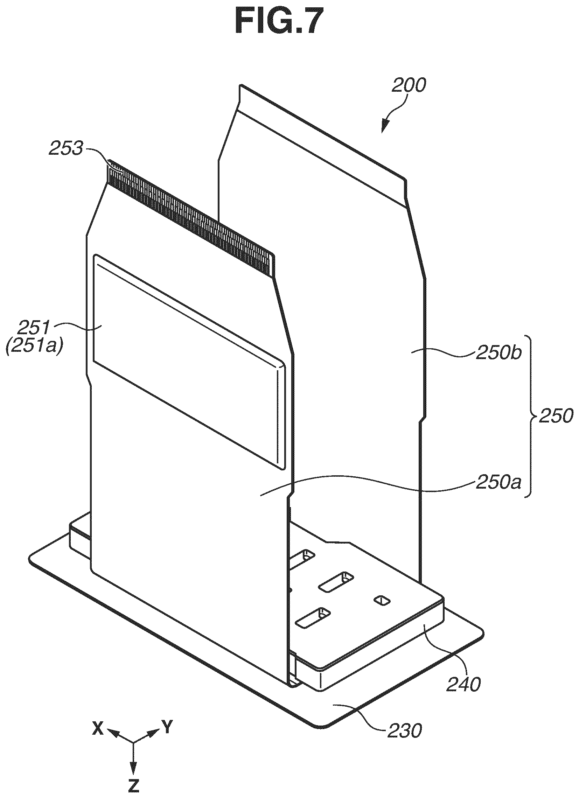

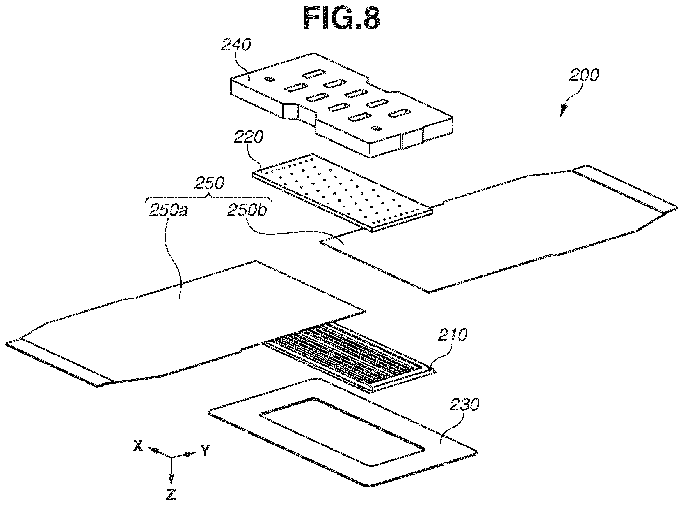

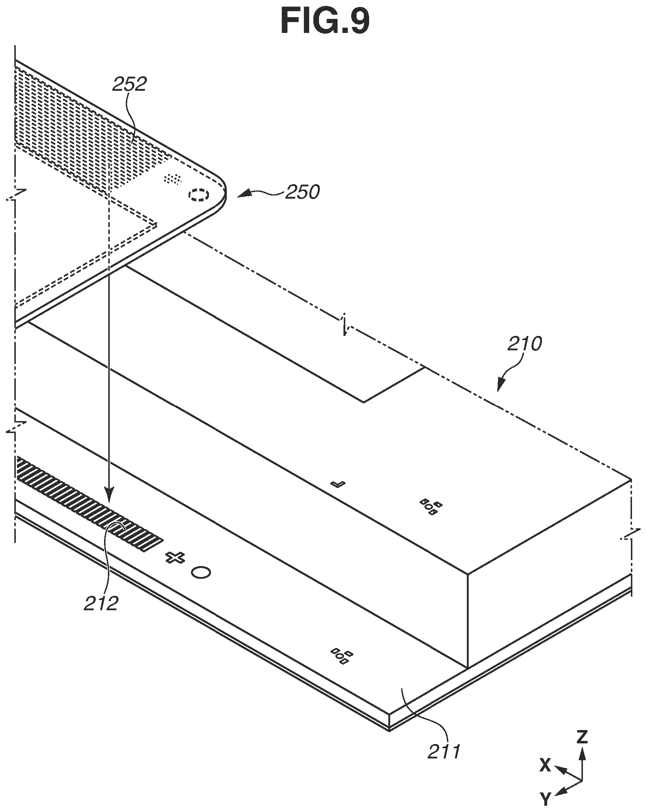

Fig. 6 is a perspective view illustrating the liquid discharge unit 200. Fig. 7 is a perspective view illustrating the liquid discharge unit 200. Fig. 8 is an exploded perspective view illustrating the liquid discharge unit 200. Fig. 9 is an enlarged view illustrating an electrode of the liquid discharge unit 200. A configuration of the liquid discharge unit 200 will be described below with reference to Figs. 6 to 9.

As illustrated in Figs. 6 to 8, the liquid discharge unit 200 includes a discharge element board 210 for discharging a liquid, a discharge element board flow path member 220 for supplying a liquid to the discharge element board 210, and a flow path member 240 for supplying a liquid to the discharge element board flow path member 220. The liquid discharge unit 200 also includes the flexible wiring boards 250 electrically connected with the discharge element board 210, and a discharge element board support member 230 bonded to a discharge surface side of the discharge element board 210.

As illustrated in Fig. 9, an electrode 212 is disposed on a thin plate 211 at both ends of the discharge element board 210. Fig. 9 is an enlarged view illustrating one end of the discharge element board 210. The end refers to an end in a direction intersecting the arrangement direction in which the discharge elements (or discharge ports) are arranged on the discharge element board 210. As illustrated in Fig. 9, when the electrode 212 and an electrode of a first electrical connection portion 252 of the flexible wiring board 250 are brought into contact, the discharge element board 210 and the flexible wiring board 250 are electrically connected. To prevent a liquid from entering an electrical connection portion and to reinforce the thin plate 211 of the discharge element board 210, the discharge element board support member 230 is bonded to a discharge surface side of the thin plate 211 as illustrated in Figs. 6 to 8. The flexible wiring board 250 is provided with the drive circuit board 251 for driving the discharge elements of the discharge element board 210 (see Fig. 5). As illustrated in Figs. 7 and 8, the flexible wiring board a 250a and the flexible wiring board b 250b are disposed to face each other so as to sandwich the discharge element board 210 from a facing direction substantially orthogonal to the arrangement direction in which the discharge elements are arranged.

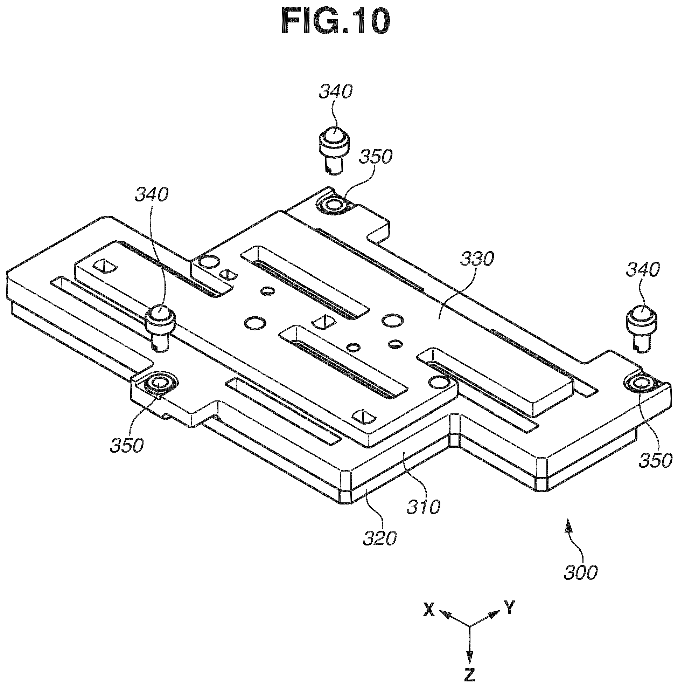

Fig. 10 is a perspective view illustrating the support unit 300 for supporting the liquid discharge units 200. The support unit 300 includes the support member 310 to which the liquid discharge units 200 are bonded, and a frame member 320 that surrounds the periphery of the liquid discharge unit 200. The support unit 300 also includes a liquid supply member 330 provided with flow paths for supplying a liquid to the liquid discharge units 200 (four liquid discharge units 200 according to the present embodiment) via the support member 310. The support unit 300 also includes the reference members 340 having a function of positioning with respect to the main body of the liquid discharge apparatus 10, and reference fixing members 350 for fixing the reference members 340 to the support member 310. Desirably, the same material is selected for the support member 310, the frame member 320, and the liquid supply member 330 in consideration of an effect of thermal expansion, for example, during an ink heating temperature adjustment or due to environmental fluctuations. Alternatively, when different materials are used for the support member 310, the frame member 320, and the liquid supply member 330, it is desirable to select materials having coefficients of linear expansion that are close as possible. This enables preventing deformation of the entire support unit 300 during the thermal expansion and deterioration of positional accuracy of the discharge element board 210 accompanying the deformation.

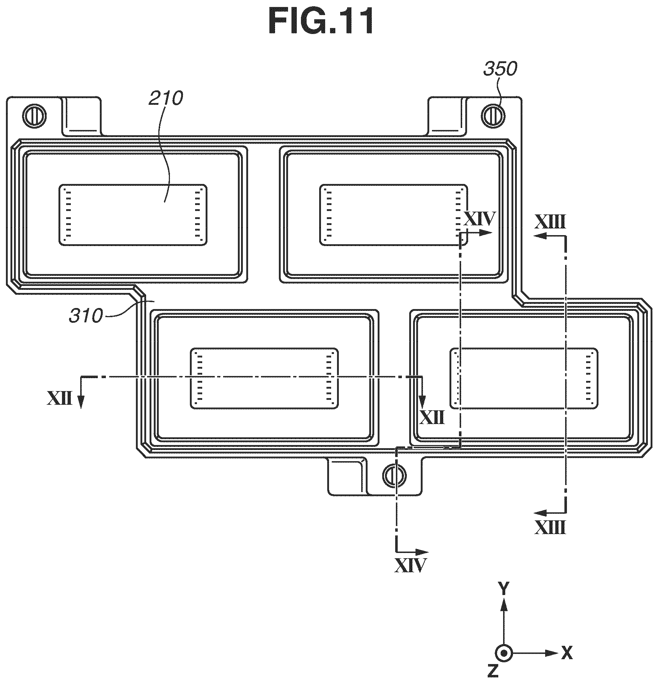

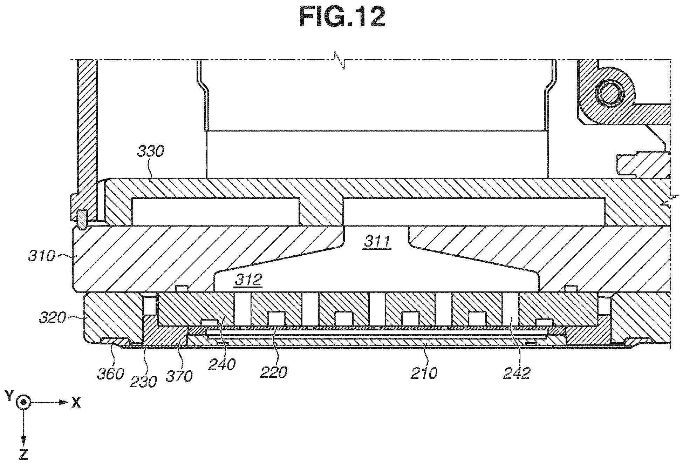

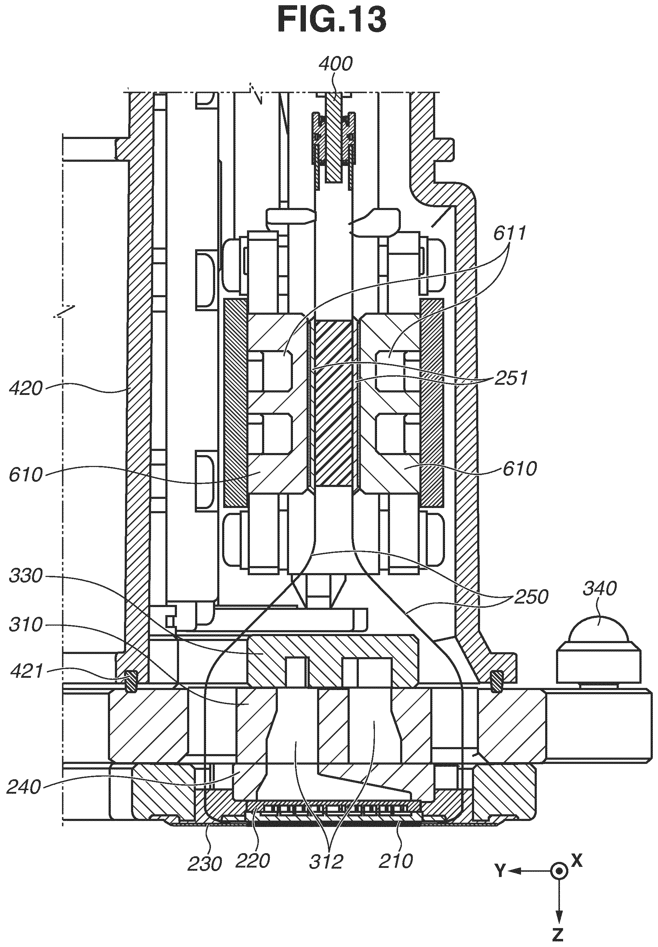

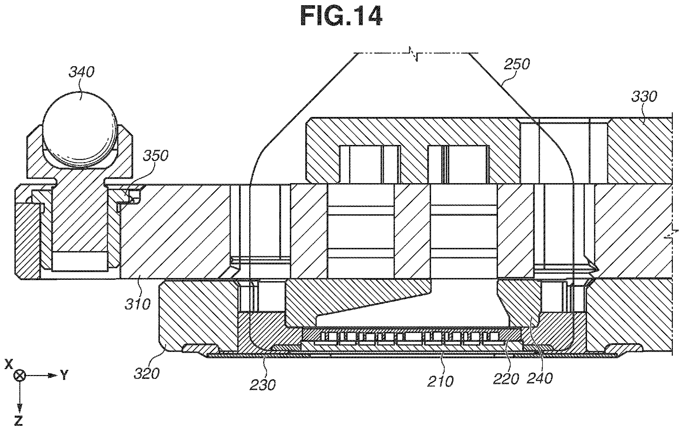

Fig. 11 is a plan view illustrating the liquid discharge head 100 in which the liquid discharge units 200 assembled to the support unit 300, as viewed from the discharge surface side. Fig. 12 is a cross-sectional view taken along line XII-XII in Fig. 11. Fig. 13 is a cross-sectional view taken along line XIII-XIII in Fig. 11. Fig. 14 is a cross-sectional view taken along line XIV-XIV in Fig. 11. Fig. 13 is a cross-sectional view taken along line XIII-XIII in Fig. 11 illustrating a state where the liquid discharge unit 200 is assembled to the support unit 300 and then other members are assembled thereto. As illustrated in Figs. 12 to 14, the flow path member 240 and the liquid supply member 330 are bonded to the support member 310, and the liquid flow paths are fluid-connected. To prevent a liquid from entering, a gap between the periphery of the discharge element board support member 230 and the frame member 320 is sealed with a periphery sealing member 360. The back surface of the discharge element board support member 230 (the surface opposite to the discharge port surface) may be sealed with a back surface sealing member 370 for reinforcement. As illustrated in Fig. 11, the support member 310 has three holes into which the reference fixing members 350 are inserted. The reference fixing members 350 are fixed to these holes, and the reference members 340 are fixed to the reference fixing members 350. The reference fixing members 350 may be integrally formed with the support member 310.

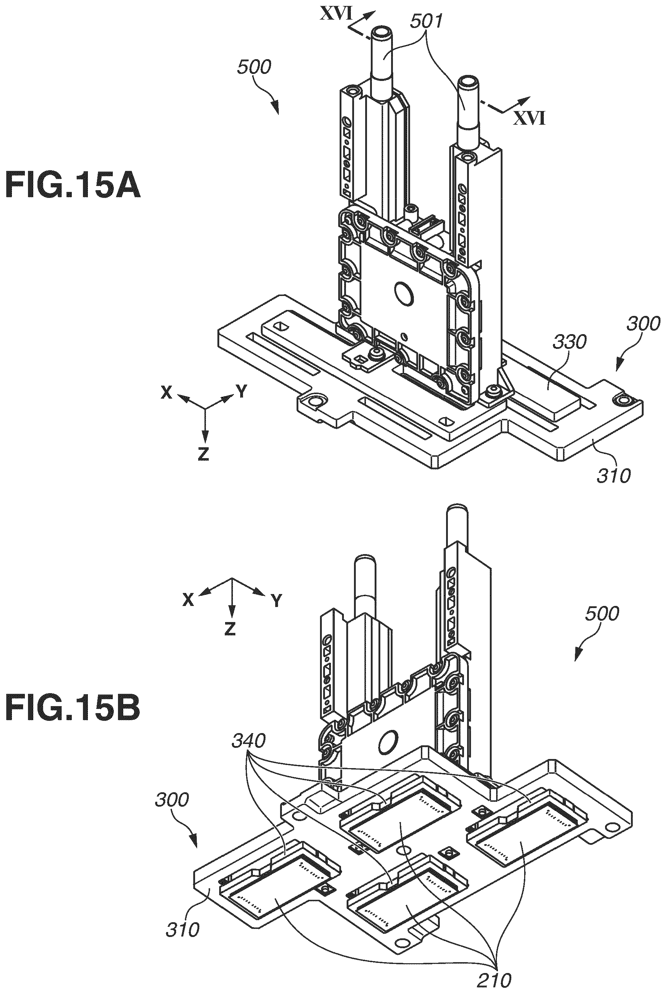

Figs. 15A and 15B illustrate a connecting configuration of liquid members between the support unit 300 and the liquid supply unit 500 of the liquid discharge head 100 according to the present embodiment. Fig. 15A is a perspective view as viewed from the top. Fig. 15B is a perspective view as viewed from the bottom. The liquid supply unit 500 includes the liquid connecting members 501 to be connected to the liquid supply members 13 of the main body of the liquid discharge apparatus 10 (see Fig. 2). Accordingly, a liquid is supplied from a supply system of the main body of the liquid discharge apparatus 10 to the liquid discharge head 100, passes through the inside of the liquid discharge head 100, and then is collected by the supply system of the main body of the liquid discharge apparatus 10. In this way, a liquid can circulate through a path of the main body of the liquid discharge apparatus 10 and a path of the liquid discharge head 100. In the liquid supply unit 500, filters (not illustrated) communicating with openings of the liquid connecting members 501 are provided to remove foreign objects in supplied ink.

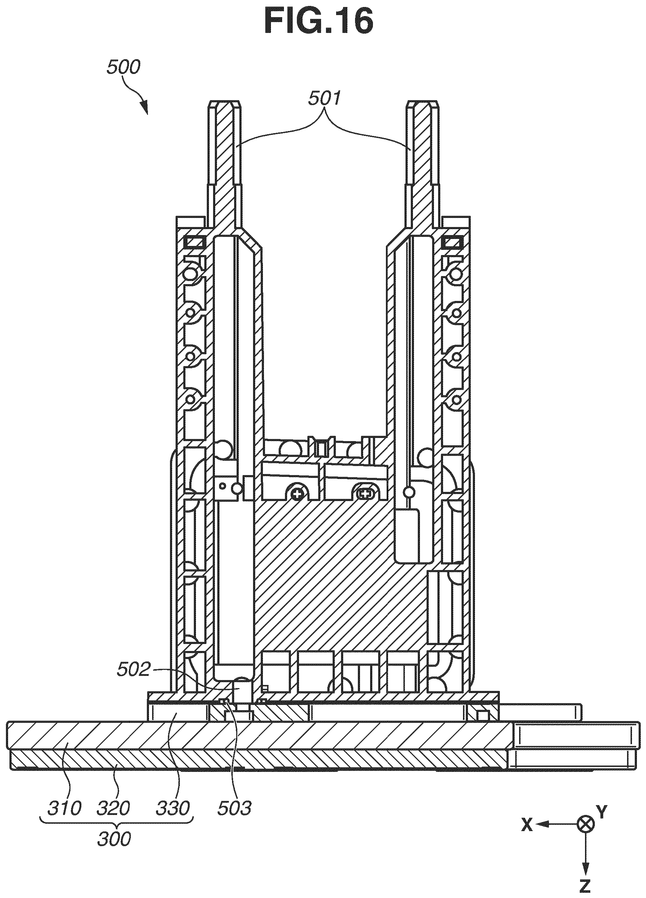

Fig. 16 is a cross-sectional view illustrating a fluid connecting portion between the liquid supply unit 500 and the liquid supply member 330. Fig. 16 is a cross-sectional view taken along line XVI-XVI in Fig. 15A. A liquid flowing through the liquid connecting members 501 from the main body of the liquid discharge apparatus 10 passes through a communication port 502 and then is supplied to the liquid supply member 330. A gap between the liquid supply unit 500 and the liquid supply member 330 is sealed with an elastic member 503.

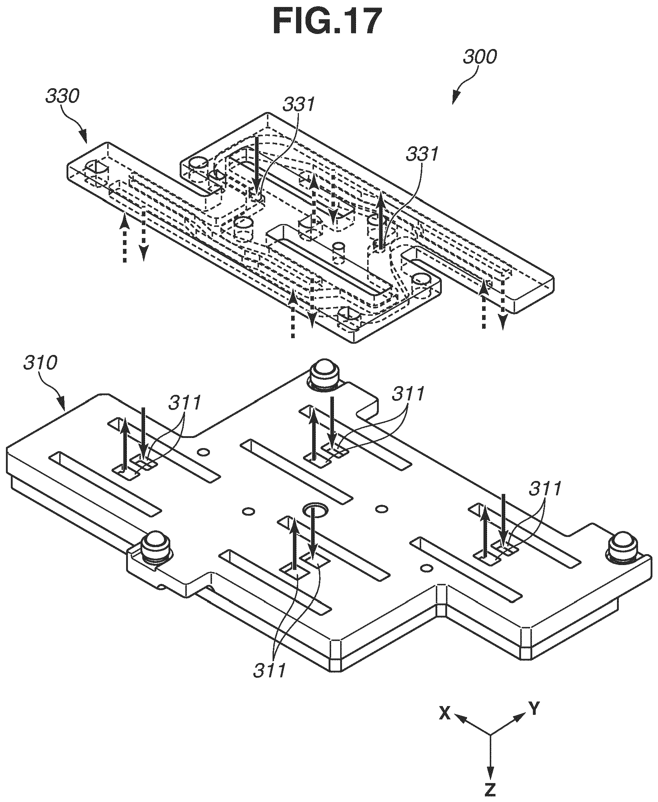

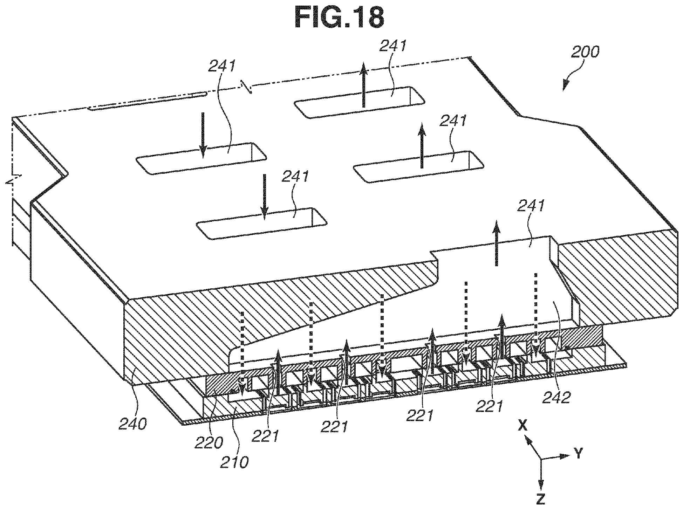

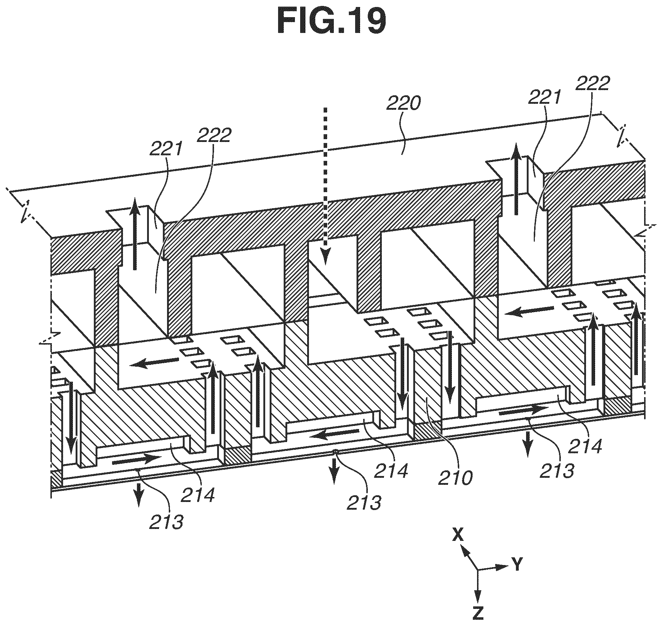

Fig. 17 illustrates a connecting configuration of liquid flow paths of the support unit 300. Fig. 18 illustrates a connecting configuration of liquid flow paths of the liquid discharge unit 200. The liquid supply unit 500 and the liquid supply member 330 in the support unit 300 are fluid-connected by first communication ports 331. In the liquid supply member 330, flow paths for distributing a liquid to the liquid discharge units 200 are formed. In this example, in one liquid supply member 330, the flow paths for distributing a liquid to four liquid discharge units 200 are formed. The liquid supply member 330 and the support member 310 are fluid-connected by a second communication port 311. As illustrated in Fig. 18, the support member 310 and each of the liquid discharge units 200 are fluid-connected by a third communication port 241 of the flow path member 240. In the flow path member 240, a liquid flow path 242 is formed. The flow path member 240 is fluid-connected with the discharge element board flow path member 220 via fourth communication ports 221. Fig. 19 illustrates a fluid-connecting configuration in the discharge element board 210. A liquid flowing in from each of the four communication ports 221 passes through a common flow path 222, is supplied to the discharge element board 210, and is discharged from a discharge port 213 by a piezoelectric element 214 as a discharge element.

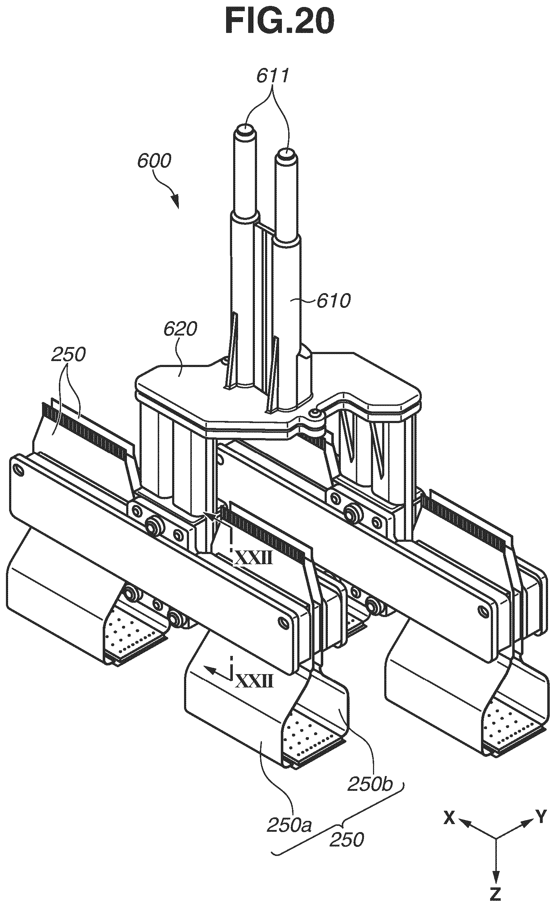

Fig. 20 is a perspective view illustrating the cooling unit 600 for cooling the drive circuit board 251.

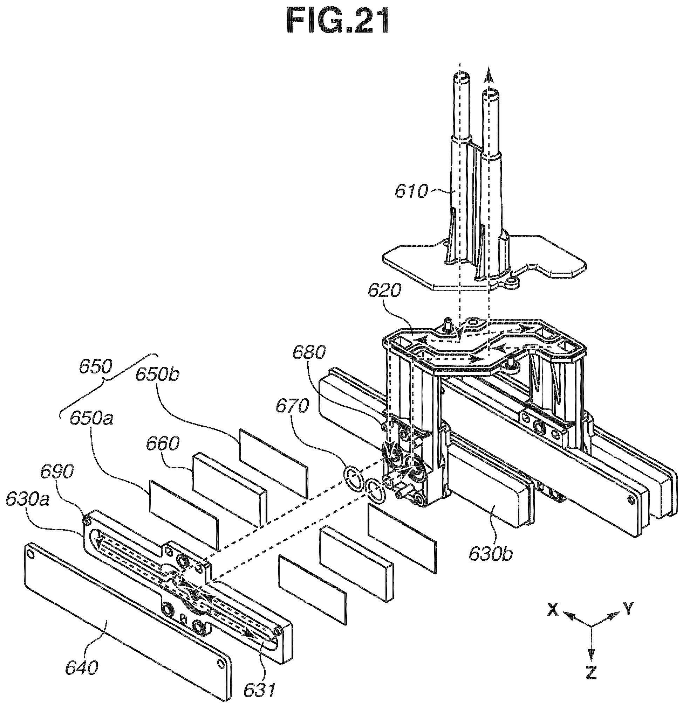

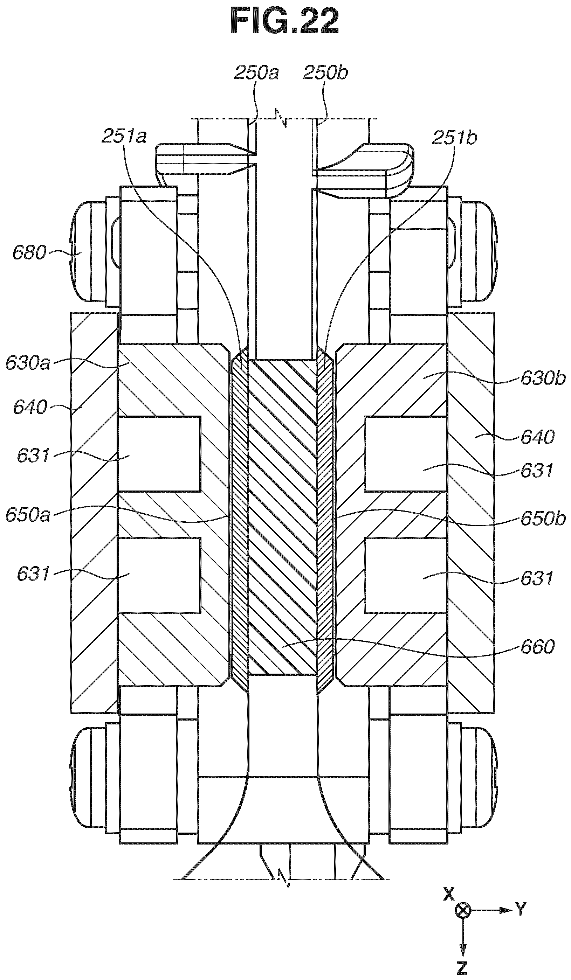

Fig. 21 is an exploded view illustrating the cooling unit 600. Fig. 22 is a cross-sectional view taken along line XXII-XXII in Fig. 20. As described above, the drive circuit boards 251 are disposed on the flexible wiring boards 250 (see Fig. 5). Fig. 20 illustrates a state where the drive circuit boards 251 are covered by the cooling unit 600. As illustrated in Fig. 20, the cooling unit 600 includes the coolant connecting members 611. The coolant connecting members 611 are connected to the coolant supply members 14 of the main body of the liquid discharge apparatus 10 (see Fig. 2). Thus, a coolant is supplied from a coolant supply system of the main body of the liquid discharge apparatus 10 to the cooling unit 600. The coolant having passed through the inside of the cooling unit 600 is collected by the coolant supply system of the main body of the liquid discharge apparatus 10. In this way, the coolant can circulate via the paths of the main body of the liquid discharge apparatus 10 and the paths of the cooling unit 600. As illustrated in Fig. 21, the coolant flowing in from one of the coolant connecting members 611 branches on a coolant flow path formed between a first coolant supply member 610 and a second coolant supply member 620. The second coolant supply member 620 and a cooling member 630 are fluid-connected via sealing members 670. The coolant branching in the second coolant supply member 620 circulates in a coolant flow path 631 formed between the cooling member 630 and a cover member 640, and flows into the second coolant supply member 620 again. Then, the coolant having flowed into the second coolant supply member 620 meets the coolant from the other path on the coolant flow path formed between the first coolant supply member 610 and the second coolant supply member 620, and flows out from the other coolant connecting member 611. The second coolant supply member 620 and the cooling member 630 are fixed with a first fixing member 680. The cooling member 630 and the cover member 640 are fixed with a second fixing member 690.

The cooling unit 600 according to the present embodiment includes four sets of the cooling member 630 and the cover member 640. The second coolant supply member 620 is separated into two cooling systems in a Y direction. Each of the cooling systems includes two sets of the cooling member 630 and the cover member 640. These two sets are disposed to face each other in the Y direction. Heat conduction members 650 in contact with the cooling members 630 are disposed between the two sets in the Y direction.

The cooling unit 600 according to the present embodiment is provided with four cooling members 630. In Figs. 20 and 21, the cooling members 630 supplied with the coolant from the second coolant supply member 620 branching toward the front left side of the drawing surface are referred to as a first cooling member 630a and a second cooling member 630b from the front left side of the drawing surface. In the following descriptions, an individual cooling member is referred to as the first cooling member 630a and the second cooling member 630b. When describing an item common to both of the cooling members, the individual cooling member is simply referred to as the cooling member 630. The heat conduction member 650 in contact with the first cooling member 630a is referred to as a first heat conduction member 650a. The heat conduction member 650 in contact with the second cooling member 630b facing the first cooling member 630a is referred to as a second heat conduction member 650b.

In this way, the first cooling member 630a and the second cooling member 630b are disposed to face each other. As illustrated in Fig. 21, in the cooling unit 600, an elastic member 660 is disposed between the first heat conduction member 650a and the second heat conduction member 650b. As illustrated in Fig. 20, the flexible wiring board 250 with the drive circuit board 251 disposed thereon is disposed between each heat conduction member 650 and the elastic member 660, and the heat conduction member 650 comes into contact with the drive circuit board 251 (see Figs. 20 and 22). Both the first cooling member 630a and the second cooling member 630b are pressed toward and fixed to the second coolant supply member 620 with the first fixing member 680.

In this way, the cooling member 630 is brought into contact with the drive circuit board 251 across the heat conduction member 650. This configuration transmits heat generated during operation of the drive circuit board 251 to the coolant in the cooling member 630. To allow the heat generated in the drive circuit board 251 to be transferred, it is desirable to select a material having as high thermal conductivity as possible, such as aluminum. The elastic member 660 is disposed between the two flexible wiring boards 250, making it possible to reliably bring the heat conduction member 650 into close contact with the drive circuit board 251.

As illustrated in Fig. 20, the two flexible wiring boards 250 each having the drive circuit board 251 are extended in the -Z direction from one discharge element board 210. The two flexible wiring boards 250 are disposed to face each other in the direction intersecting the discharge port array direction in which discharge ports 213 are formed. More particularly, the two flexible wiring boards 250 are disposed so that the drive circuit boards 251 face outward from each other. The heat conduction member 650 comes into contact with the side (outer side) of the flexible wiring board 250 where the drive circuit board 251 is disposed, and the elastic member 660 comes into contact with the side (inner side) opposite to the side where the drive circuit board 251 is disposed. The cooling members 630 come into contact with the outer side of the heat conduction members 650 so as to sandwich the heat conduction member 650. More specifically, as illustrated in Fig. 22, the first cooling member 630a, the drive circuit board a 251a, the elastic member 660, the drive circuit board b 251b, and the second cooling member 630b are disposed in this order in the direction in which the two flexible wiring boards 250 face each other. This enables efficiently cooling the drive circuit boards 251. As illustrated in Fig. 20, according to the present embodiment, one cooling member 630 is configured to cool the drive circuit boards 251 of the plurality of the discharge element boards 210.

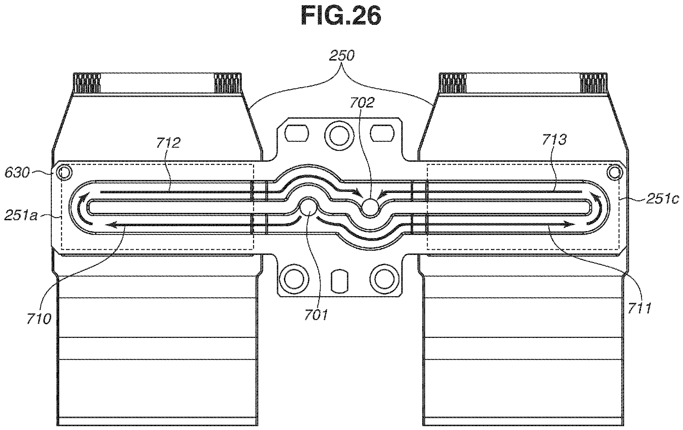

A flow of the coolant in the cooling member 630 will be described below with reference to Fig. 26. Fig. 26 is a perspective view illustrating the cooling member 630 viewed in the Y direction from the cover member 640. The drive circuit boards next to each other in the X direction are referred to as a drive circuit board a (i.e. first drive circuit board) 251a and a drive circuit board c (i.e. second drive circuit board) 251c. The X direction in this case is also referred to as a drive circuit board arrangement direction. The coolant supplied from the second coolant supply member 620 enters an inlet 701 of the cooling member 630. The coolant having entered the inlet 701 branches into a flow in a first coolant flow path (in a direction of an arrow 710) and a flow in a second coolant flow path (in a direction of an arrow 711). The coolant passes through projection surfaces of the drive circuit board a (first drive circuit board) 251a and the drive circuit board c (second drive circuit board) 251c, thus cooling the driving elements with the cooling member 630.

The coolant having passed through projecting portions of the driving elements flows in the first and the second coolant flow paths along the arrows 712 and 713, respectively. Then, the coolant flows into an outlet 702 and is discharged to the second coolant supply member 620. Since the projection surface of each of the drive circuit boards is supplied with the coolant immediately after branching from the inlet 701, the temperature of the coolant is approximately equal, making it possible to equally cool the driving elements. On the other hand, an amount of heat generation of each of the drive circuit boards is not necessarily constant because the amount of heat generation is changed by a print duty of each driven discharge element board 210. Suppose there is an example scenario where a first discharge element board provides a high print duty, and a third discharge element board provides a low print duty depending on an output image. In this case, the drive circuit board a (first drive circuit board) 251a generates a large amount of heat, and the drive circuit board c (second drive circuit board) 251c generates a small amount of heat. Since the cooling member 630 is common to the two drive circuit boards, a cooling load for the drive circuit boards having different amounts of heat generation can be dispersed by thermal conduction inside the cooling member 630 from the drive circuit board a (first drive circuit board) 251a generating the large amount of heat to the drive circuit board c (second drive circuit board) 251c generating the small amount of heat. This enables reducing the peak temperature of the driving element generating the large amount of heat in comparison with a case where an independent heat sink is provided for each driving element.

Desirably, the inlet 701 and the outlet 702 are disposed at the same height in the direction of gravity. Thus, the drive circuit boards 251 face each other, and the facing cooling members 630 can be disposed in the same form with respect to the common second coolant supply member 620. In the embodiment of the present disclosure, "the same height" may be substantially the same height, and a slight deviation is allowed as long as an intended effect can be achieved.

From the viewpoint of cooling efficiency, desirably, the coolant introduced from the inlet 701 flows through the coolant flow paths so as to be directed upward with respect to the direction of gravity and then is directed to the outlet 702.

The heat conduction member 650 has a function of transmitting heat from each of the drive circuit boards 251 to the cooling member 630. For this reason, desirably, the heat conduction member 650 has a small thermal resistance, and therefore desirably has a small thickness. Desirably, the heat conduction member 650 has elasticity to bring the cooling member 630 and the drive circuit board 251 into close contact with each other. Desirably, the heat conduction member 650 has a thickness of 8 mm or less. In the present embodiment, a heat dissipation sheet made of an acrylic resin as a base and with a dispersed filler is disposed as the heat conduction member 650. The heat dissipation sheet has a thermal conductivity of 2 [W/mK] and a thickness of 1 mm.

Desirably, the thickness of the elastic member 660 is larger than at least the thickness of the heat conduction member 650 so that the heat conduction member 650 is reliably brought into pressure contact with the cooling member 630 even if the drive circuit board 251 is inclined. More specifically, desirably, the elastic modulus (compressive strength) of the elastic member 660 is 0.01 [N/cm²] or more and 1.0 [N/cm²] or less.

In the present embodiment, the elastic member 660 is formed of a foamed member based on Ethylene Propylene Diene Monomer (EPDM), having a thickness of about 5 mm and a compressive strength of about 0.18 [N/cm²].

The material of the elastic member 660 is not limited to the above-described EPDM but may be, for example, a rubber such as a chlorinated butyl rubber or a urethane rubber, or a silicone- or elastomer-based material.

The heat conduction member 650 is not limited to the above-described heat dissipation sheet. For example, the heat conduction member 650 may be a paste-like heat conduction grease instead of a sheet-like member. While the above-described heat conduction member 650 is desirably disposed, the heat conduction member 650 may not be disposed.

The heat generation of the drive circuit board 251 according to the present embodiment is about 17 W. One liquid discharge head 100 is provided with four discharge element boards 210 (as illustrated in Fig. 1, the liquid discharge apparatus 10 is provided with eight liquid discharge heads 100). Two flexible wiring boards 250 from one discharge element board 210 are connected to each electric wiring board 400, and each of the flexible wiring boards 250 is provided with the drive circuit board 251. Therefore, the liquid discharge head 100 according to the present embodiment is provided with a total of eight drive circuit boards 251. When the coolant of the cooling unit 600 is put into the liquid discharge head 100, the temperature of the coolant is 30°C, and the flow rate can be set to about 8 cc/min or more and 30 cc/min or less for each of the drive circuit boards 251. More specifically, for the entire liquid discharge head 100, the flow rate of the coolant flowing through the coolant connecting members 611 is controlled to be 64 cc/min or more and 240 cc/min or less. This enables maintaining the temperature of each of the drive circuit boards 251 to 80°C or lower, more desirably 60°C or lower. It will be appreciated that the flow rate and/or temperature of the coolant is not limited to the specific values described, and may be configured in any suitable way for maintaining a desired temperature of the drive circuit boards 251.

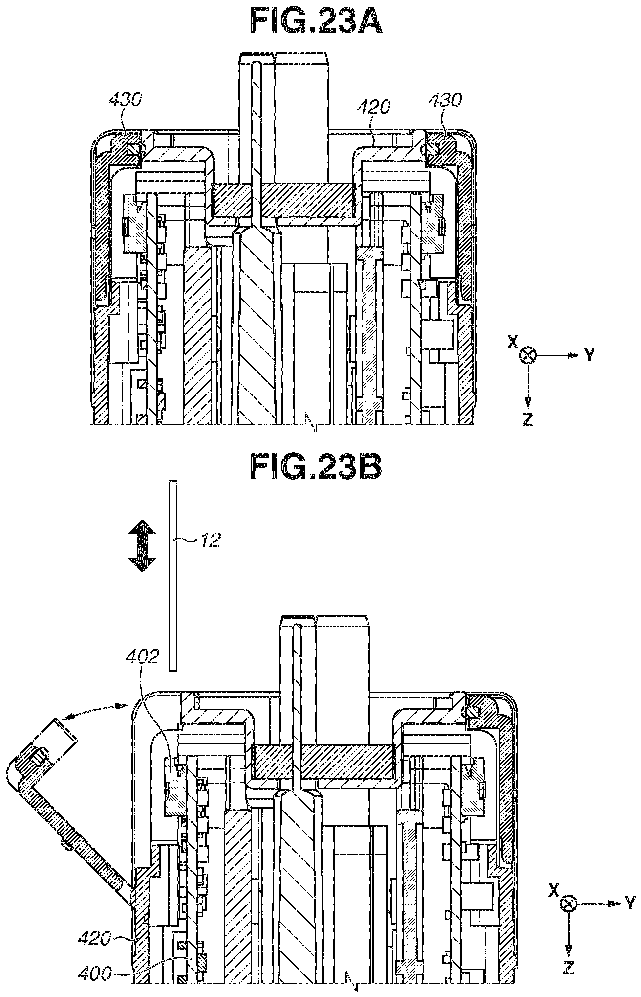

Figs. 23A and 23B are cross-sectional views illustrating an electrical connection portion between the main body of the liquid discharge apparatus 10 and the liquid discharge head 100. The electric wiring board 400 in the liquid discharge head 100 is provided with an electric connection terminal 402. When the electric connection terminal 402 connects with a liquid discharge apparatus electric wiring member 12, the liquid discharge apparatus 10 and the liquid discharge head 100 electrically connect with each other. The periphery of the electric connection terminal 402 is covered with an openable and closable electrical connection portion cover member 430.

As discussed above, the present embodiment makes it possible to uniformly cool a plurality of driving elements and use a common cooling member for the plurality of driving elements, thereby reducing the number of parts to be arranged to facilitate parts arrangement. Since the numbers of inlets and outlets are smaller than the number of driving elements, the first coolant supply member 610 and the second coolant supply member 620 can be easily arranged without making their shapes complicated. This makes it easier to support complicated arrangements of the driving elements, such as a staggered pattern. In addition, in a case where the plurality of driving elements has different amounts of heat generation, the cooling load can be dispersed to lower the peak temperature.

According to the above-described embodiment, an example has been described where one cooling member 630 cools the drive circuit boards 251 of different liquid discharge units 200. More specifically, two cooling members 630 facing each other cool the drive circuit boards 251 of two liquid discharge units 200. However, the present invention is not limited to this example. A configuration may be employed in which one cooling member 630 cools the drive circuit boards 251 of one liquid discharge unit 200. Alternatively, one cooling member 630 may cool the drive circuit boards 251 of three or more liquid discharge units 200.

In the above-described example, the flexible wiring boards having a high degree of freedom in layout are used. However, a configuration in which no flexible wiring board is used may also employed. In such a case as well, the driving elements may be cooled by applying the cooling member 630 to the drive circuit boards 251.

In the above-described example, the first coolant supply member 610, the second coolant supply member 620, the cooling member 630, and the cover member 640 are made of different materials and combined with each other. However, some or all of these members may be integrally formed by using a three-dimensional (3D) printer. Such a method requires no sealing and fixing members in combining the members, thus improving an effect of preventing coolant leakages and providing a highly reliable cooling member.

The disclosure of the present embodiments includes configurations represented by the following liquid discharge head examples and liquid discharge apparatus examples.

According to the present disclosure, the driving elements can be efficiently cooled.

While the present invention has been described with reference to embodiments, it is to be understood that the invention is not limited to the disclosed embodiments. The scope of the following claims is to be accorded the broadest interpretation so as to encompass all such modifications and equivalent structures and functions.

## Claims

1. A liquid discharge head comprising:
a first discharge element board and a second discharge element board each having a discharge element for discharging a liquid from a discharge port;
a first drive circuit board provided with a first driving element for driving the discharge element on the first discharge element board;
a second drive circuit board provided with a second driving element for driving the discharge element on the second discharge element board; and
a cooling member configured to come into contact with the first and the second drive circuit boards,
wherein the cooling member includes:
an inlet configured to introduce a coolant from outside;
an outlet configured to guide the coolant to the outside;
a first coolant flow path configured to connect the inlet and the outlet and cool the first drive circuit board; and
a second coolant flow path configured to connect the inlet and the outlet and cool the second drive circuit board, and
wherein the first and the second coolant flow paths are disposed to sandwich the inlet.

2. The liquid discharge head according to claim 1, wherein the inlet and the outlet of the cooling member are disposed at the same height in a direction of gravity.

3. The liquid discharge head according to claim 1 or 2, further comprising a coolant supply member configured to supply the coolant to the cooling member.

4. The liquid discharge head according to any one of claims 1 to 3, wherein a heat conduction member is disposed to be sandwiched between the cooling member and the first drive circuit board.

5. The liquid discharge head according to any one of claims 1 to 4, wherein a plurality of discharge element boards are arranged in a staggered pattern.

6. The liquid discharge head according to claim 5, wherein the cooling member cools a plurality of drive circuit boards connected to a plurality of discharge element boards in one row among the plurality of discharge element boards arranged in the staggered pattern.

7. A liquid discharge apparatus comprising:
a liquid discharge head according to any one of claims 1 to 6:
a liquid supply member configured to supply a liquid to the liquid discharge head; and
a coolant supply member configured to supply a coolant to the liquid discharge head.
